# EUROPEAN PATENT APPLICATION

(11) **EP 1 653 789 A1**
(43) Date of publication of application: **03.05.2006**
(21) Application number: 04746998.6
(22) Date of filing: 05.07.2004
(51) Int. Cl.: H05K 3/46

(54) **PRINTED-WIRING BOARD AND METHOD OF PRODUCING THE SAME**

(30) Priority: 30.07.2003 JP 2003283129
(71) Applicant: International Business Machines Corporation, Armonk, NY 10504 (US)
(72) Inventor: MORI, Hiroyuki, c/o Yasu site, IBM Japan Ltd., Yasu-gun, Shiga 5202362 (JP); YAMANAKA, Kimihiro, c/o Yasu site, IBM Japan Ltd., Yasu-gun, Shiga 5202362 (JP); KODAMA, Yasushi, c/o Yasu site, IBM Japan Ltd., Yasu-gun, Shiga 5202362 (JP)
(74) Representative: Roberts, Scott Anthony
(86) International application number: PCT/JP2004/009529
(87) International publication number: WO 2005/013653

(57) **Abstract**

[Object]

To provide a printed wiring board that can prevent occurrence of a short.

[Constitution]

A printed wiring board 100 has a via land 2A, a glass epoxy resin layer 3, a via conductor 6, and a block layer 4A. The via land 2A is formed on a core layer 1. The glass epoxy resin layer 3 is formed on the core layer 1 and the via land 2A. The via conductor 6 is formed on the via land 2A. The block layer 4A is formed on the via land 2A, between the via conductor 6 and the glass epoxy resin layer 3.

## Description

### 2. Detailed Description of the Invention:

### [Field of the Invention]

The present invention relates to a printed wiring board and its manufacturing method and, more specifically, relates to a printed wiring board having a base substrate such as a core layer and a method of manufacturing such a printed wiring board.

### [Background Art]

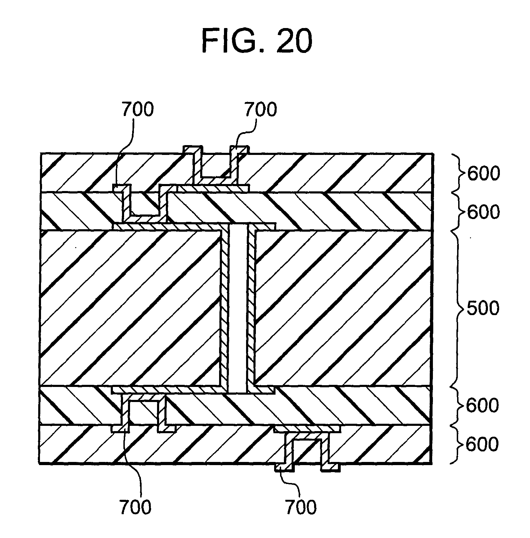

In recent years, attention has been paid among printed wiring boards to build-up wiring boards that are capable of improvement in packaging density. As shown in Fig. 20, a build-up wiring board has a structure in which a plurality of build-up layers 600 are stacked on a core layer 500 serving as a base, and a plurality of vias 700 are formed in the build-up layers 600 for establishing electrical connection between the layers.

For realizing high-density packaging, it is necessary to shorten a distance (pitch) between the vias. However, if the pitch between the vias is small, a short is caused due to migration or back plating. The migration is a phenomenon that when metal is in contact with an insulating layer, the insulating layer adsorbs water so that the metal moves into the insulating layer. In a printed wiring board, shorts due to the migration are generated mainly by the following two causes.

(1) Generation of Migration due to CAF (Conductive Anodic Filaments)
In the printed wiring board, a glass epoxy resin material is used for an insulating layer. The glass epoxy resin material is obtained by impregnating glass fibers with an epoxy resin. When forming vias in a glass epoxy resin layer by the copper plating method, a chemical liquid used in the copper plating method enters gaps between the glass fibers and the epoxy resin inside the glass epoxy resin layer. When a high-temperature high-humidity bias test is applied to the printed wiring board in this state, part of a copper plating is ionized due to moisture of the chemical liquid so as to move in the gaps between the glass fibers and the epoxy resin, and then is deposited (migration). As a result, a short is caused between the vias.

(2) Generation of Migration due to Hollow Fiber Phenomenon
The glass fibers included in the glass epoxy resin layer used in the printed wiring board include hollow glass fibers. When the high-temperature high-humidity bias test is applied to the printed wiring board, copper ions move within the hollow glass fibers and then are deposited so that a short is caused between the vias.

On the other hand, the back plating is a phenomenon that when forming a copper plating layer by the copper plating method, the gaps between the glass fibers and the epoxy resin of the glass epoxy resin layer are copper plated. The back plating also causes a short between the vias.

For suppressing these shorts, it is necessary to increase the pitch between the vias to some degree. To this end, the pitch between the vias can not be narrowed and therefore the packaging density can not be increased. Further, even if the pitch between the vias is ensured to some degree, there still exits possibility of occurrence of a short due to the migration or back plating, thus also raising a problem in reliability.
[Patent Literature 1] JP-A-H09-312461
[Patent Literature 2] JP-A-H09-237950

### [Disclosure of the Invention]

### [Problems to be solved by the Invention]

It is an object of the present invention to provide a printed wiring board that can prevent occurrence of a short, and a method of manufacturing such a printed wiring board.

It is another object of the present invention to provide a printed wiring board that enables high-density packaging, and a method of manufacturing such a printed wiring board.

### [Means for solving the Problems]

A printed wiring board according to the present invention comprises a base substrate, a land conductor layer, an insulating layer, a via conductor layer, and a block layer. The land conductor layer is provided on the base substrate at least in part thereof. The insulating layer is provided on the base substrate and the land conductor layer, has a via hole reaching the land conductor layer, and contains glass fibers. The via conductor layer covers a surface of the via hole and a surface of the insulating layer at least in the vicinity of an opening of the via hole and is connected to the land conductor layer. The block layer is provided between the surface of the via hole and the via conductor layer for preventing migration to the via conductor layer through the glass fibers inside the insulating layer. Herein, the base substrate represents not only a core layer but also a build-up layer.

In the printed wiring board according to the present invention, the block layer is formed between the via conductor layer and the insulating layer. The block layer can prevent the migration or back plating caused by a contact between the via conductor layer and the insulating layer, thereby preventing occurrence of a short. Further, since the short can be prevented, the pitch between via lands can be narrowed in comparison with the conventional one. Consequently, the packaging density can be increased.

Preferably, the block layer covers an inner wall of the insulating layer at least over a range from an uppermost end to a lowermost end where the glass fibers inside the insulating layer exist.

The migration or back plating is caused by a contact between the glass fibers in the insulating layer and the via conductor layer. Therefore, a short can be prevented by forming the block layer so as to prevent the contact between the glass fibers in the insulating layer and the via conductor layer.

Preferably, a lower end of the block layer is located above a surface of the land conductor layer.

In this case, it is not necessary that the block layer is formed up to the surface of the land conductor layer. Therefore, a time required for a process of forming the block layer can be shortened in the manufacturing of the printed wiring board.

Preferably, the insulating layer is formed by a resin layer in which the glass fibers are buried.

Preferably, the block layer is formed by an insulating layer.

More preferably, the block layer is formed by a resin layer.

A method of manufacturing a printed wiring board according to the present invention comprises the steps of (a) preparing a base substrate; (b) providing a land conductor layer on the base substrate at least in part thereof; (c) providing an insulating layer containing glass fibers so as to cover the base substrate and the land conductor layer; (d) providing a via hole in the insulating layer, the via hole reaching the land conductor layer; (e) providing a block layer on a surface of the via hole for preventing migration through the glass fibers inside the insulating layer; and (f) providing a via conductor layer covering the block layer and a surface of the insulating layer at least in the vicinity of an opening of the via hole and connected to the land conductor layer.

In the printed wiring board according to the present invention, the block layer is formed between the via conductor layer and the insulating layer. The block layer can prevent the migration or back plating caused by a contact between the via conductor layer and the insulating layer, thereby preventing occurrence of a short. Further, since the short can be prevented, the pitch between via lands can be narrowed in comparison with the conventional one. Consequently, the packaging density can be increased.

A method of manufacturing a printed wiring board according to the present invention comprises the steps of (a) preparing a base substrate; (b) providing a land conductor layer on the base substrate at least in part thereof; (c) providing an insulating layer containing glass fibers so as to cover the base substrate and the land conductor layer; (d) providing a first via hole in the insulating layer over the land conductor layer; (e) providing a block layer on a surface of the first via hole for preventing migration through the glass fibers inside the insulating layer; (f) providing a second via hole in the first via hole where the block layer is provided, the second via hole reaching the land conductor layer; and (g) providing a via conductor layer covering a surface of the second via hole, the block layer, and a surface of the insulating layer at least in the vicinity of an opening of the first via hole and connected to the land conductor layer.

In the printed wiring board according to the present invention, the block layer is formed between the via conductor layer and the insulating layer. The block layer can prevent the migration or back plating caused by a contact between the via conductor layer and the insulating layer, thereby preventing occurrence of a short. Further, since the short can be prevented, the pitch between via lands can be narrowed in comparison with the conventional one. Consequently, the packaging density can be increased.

A method of manufacturing a printed wiring board according to the present invention comprises the steps of (a) preparing a base substrate; (b) providing a land conductor layer on the base substrate at least in part thereof; (c) providing an insulating layer containing glass fibers so as to cover the base substrate and the land conductor layer; (d) providing a first via hole in the insulating layer over the land conductor layer; (e) providing a second via hole in the first via hole, the second via hole reaching the land conductor layer, and providing a block layer on a surface of the first via hole for preventing migration through the glass fibers inside the insulating layer; and (f) providing a via conductor layer covering a surface of the second via hole, the block layer, and a surface of the insulating layer at least in the vicinity of an opening of the first via hole and connected to the land conductor layer.

In the printed wiring board according to the present invention, the block layer is formed between the via conductor layer and the insulating layer. The block layer can prevent the migration or back plating caused by a contact between the via conductor layer and the insulating layer, thereby preventing occurrence of a short. Further, since the short can be prevented, the pitch between via lands can be narrowed in comparison with the conventional one. Consequently, the packaging density can be increased. Furthermore, the second via hole and the block layer can both be formed.

Preferably, the step (e) of providing the second via hole and the block layer comprises the steps of filling the first via hole with an insulating material; and removing a columnar portion, extending from a surface of the filled insulating material to reach a surface of the land conductor layer, of the filled insulating material and the insulating layer between a bottom of the first via hole and the surface of the land conductor layer so as to leave the filled insulating material of a predetermined thickness on the surface of the first via hole.

In this case, after filling the first via hole with the insulating material, the second via hole is formed by processing the filled insulating material and the insulating layer between the first via hole and the surface of the land conductor layer. In this event, the insulating material of the predetermined thickness remains on the surface of the first via hole so that the remaining insulating material serves to be the block layer. Therefore, the formation of the block layer is facilitated.

Preferably, a lower end of the first via hole is located below a lowermost portion of the glass fibers inside the insulating layer and above the surface of the land conductor layer.

In this case, inasmuch as it is not necessary that the first via hole is provided up to the surface of the land conductor layer in the step of providing the first via hole, a time required for providing the first via hole can be shortened. Further, since the migration or back plating is caused by a contact between the glass fibers in the insulating layer and the via conductor layer, a short can be prevented by forming the block layer so as to prevent the contact between the glass fibers in the insulating layer and the via conductor layer.

### [Best Mode for Carrying Out the Invention]

Hereinbelow, preferred embodiments of the present invention will be described in detail with reference to the drawings. The same or corresponding portions are assigned the same reference symbols in the figures to thereby incorporate the description thereof.

### [First Embodiment]

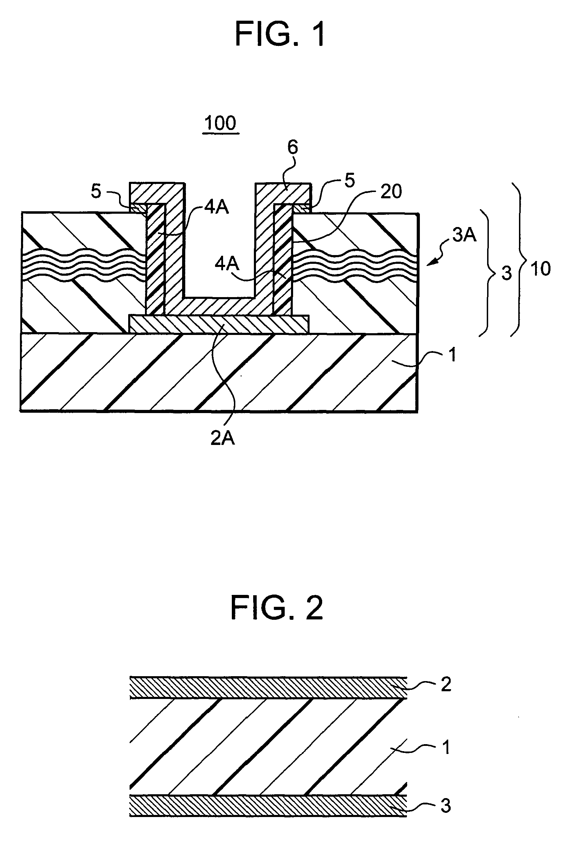

Referring to Fig. 1, a printed wiring board 100 according to this embodiment comprises a core layer 1 and a build-up layer 10. The build-up layer 10 comprises a via land 2A, a glass epoxy resin layer 3, a block layer 4A, a copper foil 5, and a via conductor 6. The via land 2A is in the form of a copper foil disk and is formed on the core layer 1. The glass epoxy resin layer 3 is formed on the core layer 1 and the via land 2A. The glass epoxy resin layer 3 is obtained by impregnating glass fibers 3A with an epoxy resin. The glass epoxy resin layer 3 is formed with a via hole 20. The via hole 20 is formed into a cylindrical shape having a depth from the surface of the glass epoxy resin layer 3 to the surface of the via land 2A. The block layer 4A is formed into a tubular shape on a side surface of the via hole 20. The block layer 4A is made of a thermosetting resin such as an epoxy resin. The via conductor 6 is formed in the via hole 20 where the block layer 4A is formed. The via conductor 6 comprises a disk-shaped bottom portion formed on the via land 2A, a tubular portion formed along an inner periphery of the block layer 4A, and an annular portion formed on the upper side of the tubular portion. An inner periphery of the annular portion and an inner periphery of the tubular portion are smoothly joined to each other. An outer periphery of the annular portion is larger in diameter than the via hole 20 so as to extend over part of the glass epoxy resin layer 3. The via conductor 6 is formed by copper plating. Specifically, the via conductor 6 is formed by electrolytic copper plating after carrying out electroless copper plating, which will be described later. The copper foil 5 is formed on the glass epoxy resin layer 3 on the lower side of the annular portion of the via conductor 6.

In the printed wiring board 100, even when there are gaps between the glass fibers 3A and the epoxy resin inside the glass epoxy resin layer 3 or even when part of the glass fibers 3A are hollow, the migration or back plating is not generated so that a short can be prevented. This is because, since the block layer 4A is provided between the glass epoxy resin layer 3 and the via conductor 6, the copper plating forming the via conductor 6 or a chemical liquid used for the copper plating does not permeate into the gaps between the glass fibers 3A and the epoxy resin or into the hollow glass fibers.

Incidentally, the via land 2A has the disk shape in this embodiment, but may have another shape. Further, the via hole 20 has the cylindrical shape in this embodiment, but may have a conical shape or another shape.

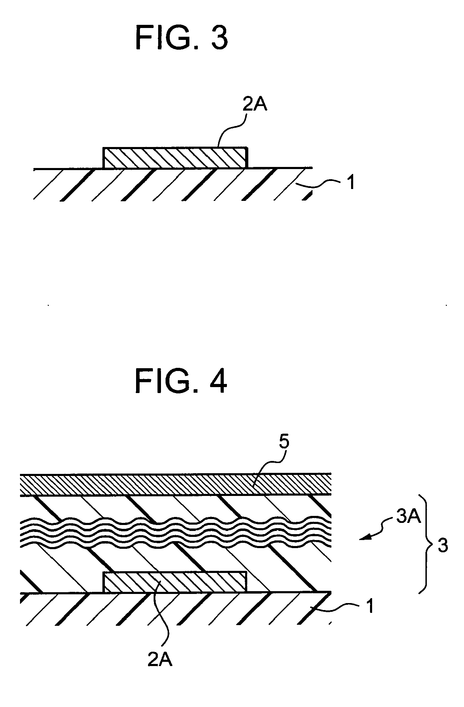

Now, description will be made of a method of manufacturing the printed wiring board 100 having the foregoing structure. Figs. 2 to 11 are sectional views for describing the manufacturing method for the printed wiring board 100 shown in Fig. 1. Referring to Fig. 2, a core layer 1 is made of a glass epoxy resin material. Copper foils 2 are formed on upper and lower surfaces of the core layer 1. As shown in Fig. 3, the copper foil 2 formed on the core layer 1 is etched by the subtractive method to be thereby formed as a via land 2A.

After forming the via land 2A, as shown in Fig. 4, a prepreg in the form of a semi-cured glass epoxy resin layer 3 is placed on the core layer 1 and the via land 2A, then a copper foil 5 is placed on the glass epoxy resin layer 3, and then, they are joined together under pressure using a laminating press machine while heating them under vacuum (lamination). In this event, a thickness of the glass epoxy resin layer 3 is, for example, 60µm, and a thickness of the copper foil 5 is, for example, 12µm.

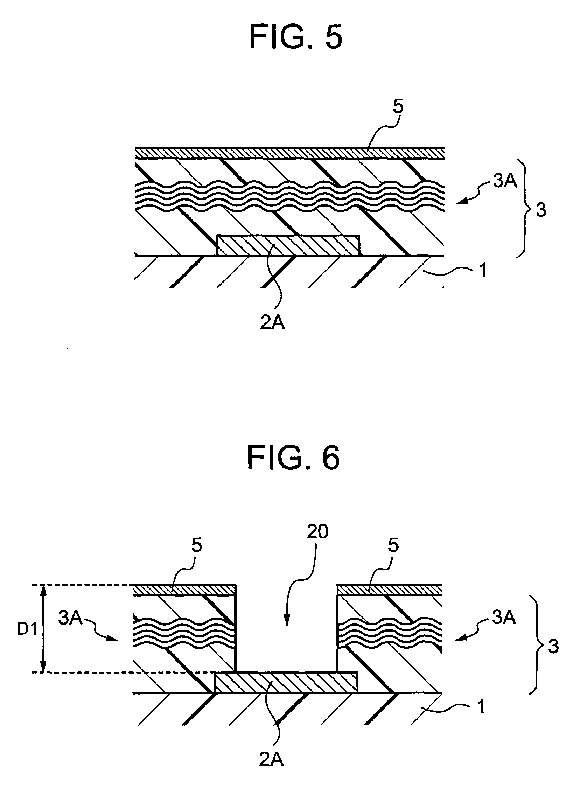

After the lamination, as shown in Figs. 5 and 6, a via hole 20 is formed in the copper foil 5 and the glass epoxy resin layer 3 for the purpose of via formation. First, as shown in Fig. 5, the copper foil 5 is subjected to soft etching so as to have a thickness of several micrometers for facilitating formation of the via hole 20. After the soft etching, as shown in Fig. 6, the via hole 20 is formed in the copper foil 5 and the glass epoxy resin layer 3. A UV (Ultra-Violet) laser or a carbon dioxide laser is used for forming the via hole 20. Upon forming the via hole 20, the laser energy amount is first set to a value necessary for a laser beam to pass through the copper foil 5 of several micrometers. After the laser beam passes through the copper foil 5, the laser energy amount is reduced to a value that can process the glass epoxy resin material but can not process the copper. By changing the energy state in this manner, the laser processing is carried out into a depth D1 from the surface of the copper foil 5 to the surface of the via land 2A. Since the energy amount is small, the via land 2A is not laser-processed while only the glass epoxy resin layer 3 is laser-processed, so that the via hole 20 is formed.

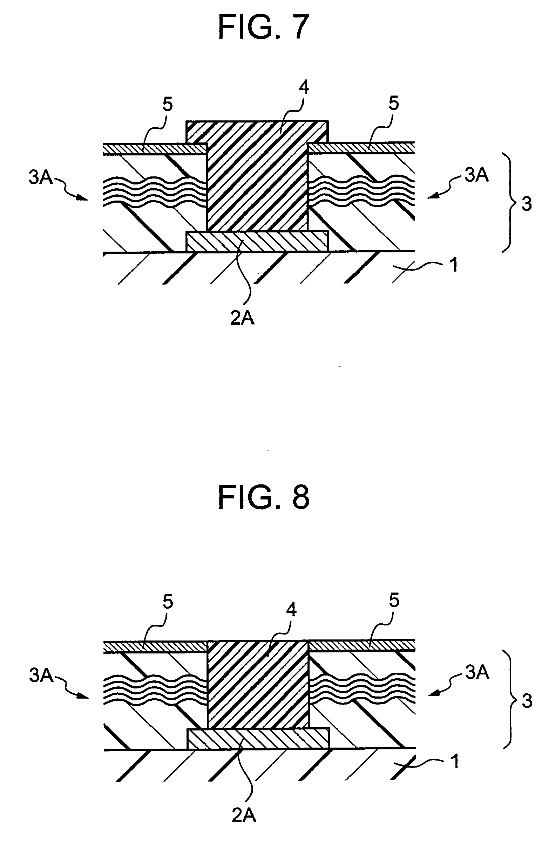

After the laser processing, as shown in Fig. 7, the via hole 20 is filled with a resin by the screen printing method using a screen mask to form an insulating layer 4. A hole diameter of the screen mask is determined taking into account a hole diameter of the via hole 20, a processing accuracy upon the laser processing, and a positioning accuracy of the screen mask in the screen printing method. As an ink for filling the hole, a thermosetting resin such as an epoxy resin is used. After forming the insulating layer 4 in the via hole 20 by the screen printing method, part of the insulating layer 4 projecting from the surface of the copper foil 5 is removed by abrasion as shown in Fig. 8.

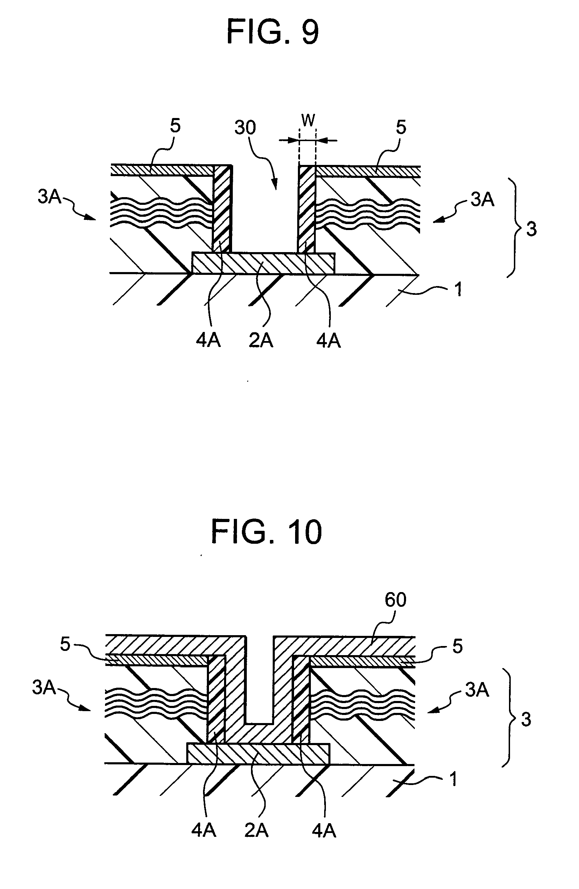

After eliminating a difference in level between the surface of the insulating layer 4 and the surface of the copper foil 5 by abrasion, a via hole 30 is formed in the insulating layer 4 by laser processing as shown in Fig. 9. The laser may be the UV laser or the carbon dioxide laser. The energy amount is set to a value that can process the insulating layer 4 but can not process the copper. By forming the via hole 30 by the laser processing, the insulating layer 4 is formed into a tubular block layer 4A. In this event, the laser processing is carried out so that W (see Fig. 9) of the tubular block layer 4A derived by (outer diameter - inner diameter)/2 becomes about several micrometers. A hole diameter of the via hole 30 formed in this event is, for example, 30 to 50µm.

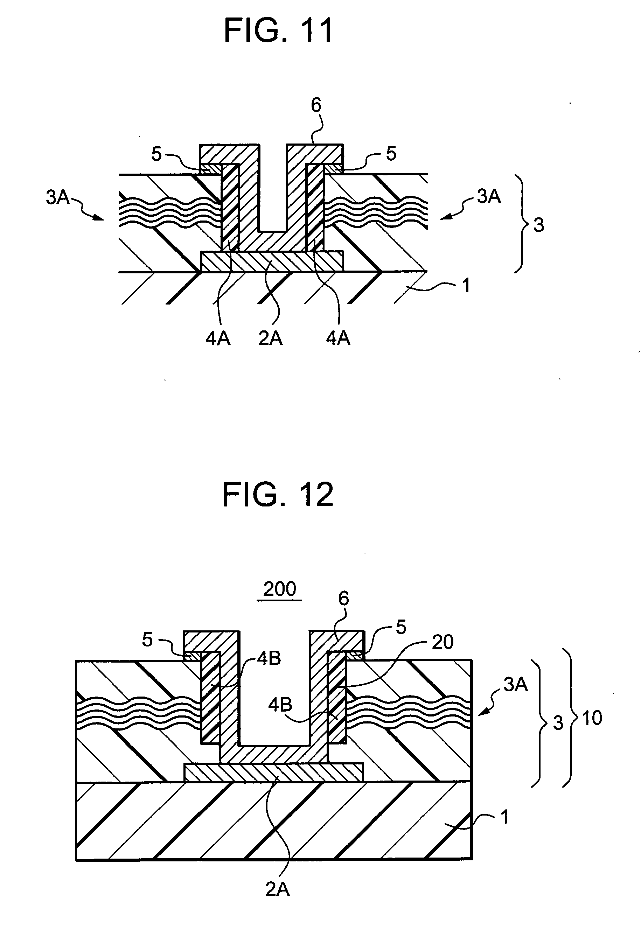

After processing the insulating layer 4 to have the via hole 30 in the block layer 4A, a via conductor 6 is formed as shown in Figs. 10 and 11. As shown in Fig. 10, a copper plating layer 60 of several micrometers is formed on the surfaces by electroless copper plating, and then the thickness of the copper plating layer 60 is increased to ten-odd micrometers by electrolytic copper plating. After forming the copper plating layer 60, as shown in Fig. 11, an unnecessary part of the copper plating layer 60 is removed to form the via conductor 6 by the subtractive method.

Through the foregoing processes, the block layer 4A is formed between the via conductor 6 and the glass epoxy resin layer 3 in the printed wiring board 100. Therefore, the via conductor 6 and the glass epoxy resin layer 3 are not in direct contact therebetween. As a result, occurrence of the migration or back plating can be suppressed so that a short can be prevented.

### [Second Embodiment]

Referring to Fig. 12, a printed wiring board 200 according to the second preferred embodiment differs from the printed wiring board 100 of Fig. 1 in that a block layer 4B is formed instead of the block layer 4A. In the printed wiring board 100 (Fig. 1), the block layer 4A is formed into the tubular shape around the via conductor 6 and has a lower end contacting with the via land 2A. On the other hand, in the printed wiring board 200 (Fig. 12), although the block layer 4B is formed into a tubular shape around a via conductor 6, a lower end thereof does not contact with a via land 2A. That is, a glass epoxy resin layer 3 is interposed between the lower end of the block layer 4B and the via land 2A.

The migration or back plating is generated in a region, within the glass epoxy resin layer 3, where glass fibers 3A are included. The position of the glass fibers 3A inside the glass epoxy resin layer 3 can be easily known upon manufacturing a build-up layer 10. Therefore, it is sufficient to form the block layer 4B between the glass fibers 3A and the via conductor 6 for preventing occurrence of the migration or back plating.

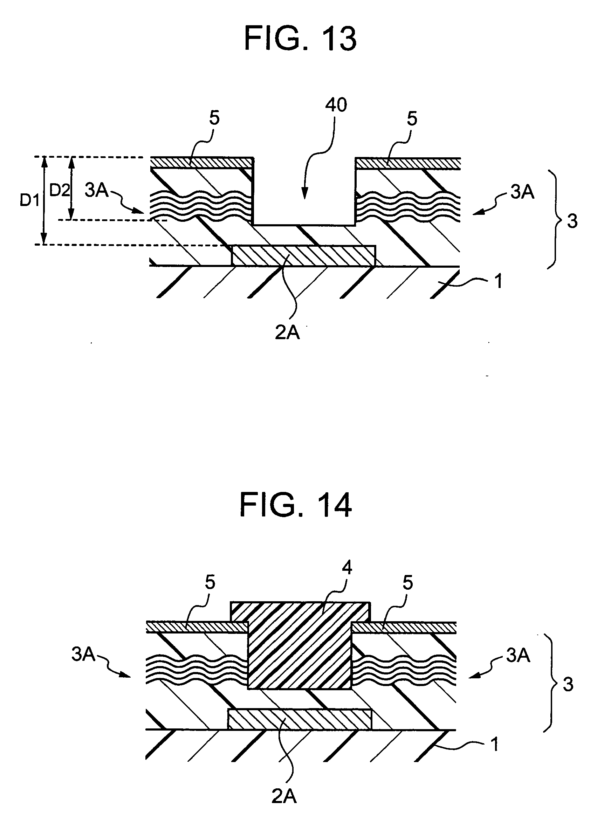

Now, description will be made of a method of manufacturing the printed wiring board 200 having the foregoing structure. Figs. 13 to 18 are sectional views for describing the manufacturing method for the printed wiring board 200 shown in Fig. 12. Inasmuch as processes of forming a via land 2A on a core layer 1, then stacking a prepreg of a glass epoxy resin layer 3 and a copper foil 5 and carrying out lamination thereof, and then soft-etching the copper foil 5 are the same as the processes (Figs. 2 to 5) in the first preferred embodiment, description thereof is not repeated.

Referring to Fig. 13, after soft-etching the copper foil 5, a via hole 40 is formed in the copper foil 5 and the glass epoxy resin layer 3 by laser processing. Assuming that a depth of the via hole 40 is D, a depth from the surface of the copper foil 5 to an upper surface of the via land 2A is D1, and a depth from the surface of the copper foil 5 to a lowermost portion of the glass fibers 3A is D2, the laser processing is carried out so that the depth D of the via hole 40 becomes D2≤D<D1.

The depth of the via hole 40 in the printed wiring board 200 is smaller than the depth of the via hole 20 in the printed wiring board 100. Therefore, a laser processing time of the via hole 40 becomes shorter than a laser processing time of the via hole 20 so that the productivity can be improved more in the printed wiring board 200 than in the printed wiring board 100.

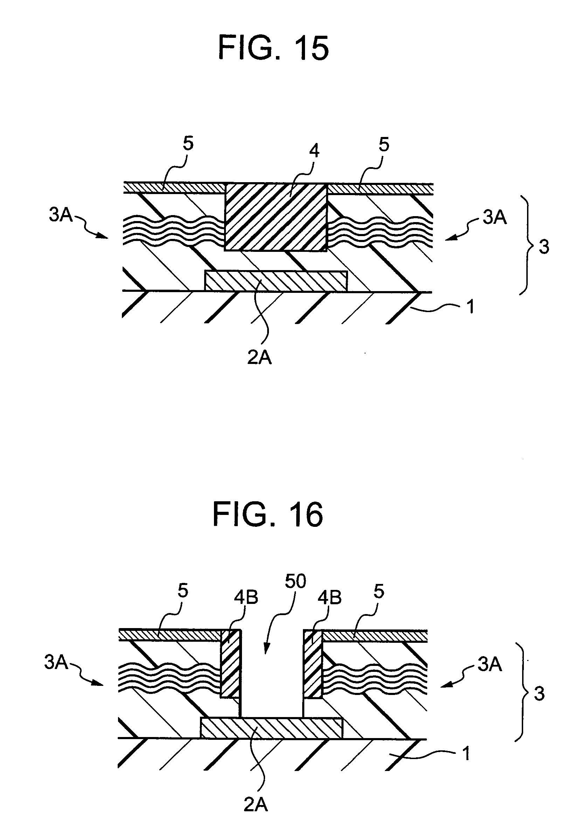

After the laser processing, as shown in Fig. 14, the via hole 40 is filled with a resin by the screen printing method to form an insulating layer 4. Thereafter, as shown in Fig. 15, part of the insulating layer 4 projecting from the surface of the copper foil 5 is removed by abrasion.

After the abrasion, a columnar portion, extending from the surface of the insulating layer 4 to reach the surface of the via land 2A, of the insulating layer 4 and the glass epoxy resin layer 3 between the bottom of the via hole 40 and the surface of the via land 2A is removed by laser processing so as to leave the insulating layer 4 of a predetermined thickness on the surface of the via hole 40, thereby forming a via hole 50 as shown in Fig. 16. As a result, the insulating layer 4 is formed into a tubular block layer 4B.

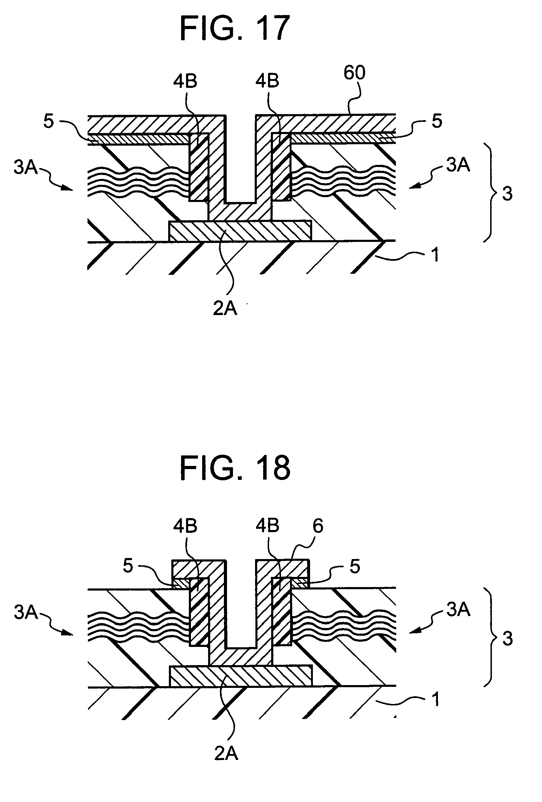

After the laser processing, a via conductor 6 is formed on the wiring board as shown in Figs. 17 and 18. First, a copper plating layer 60 is formed by electroless copper plating and electrolytic copper plating as shown in Fig. 17, and then the via conductor 6 is formed by the subtractive method as shown in Fig. 18.

The depth of the block layer 4B of the printed wiring board 200 according to the second preferred embodiment is smaller than the depth of the block layer 4A of the printed wiring board 100 according to the first preferred embodiment. Therefore, a time required for the laser processing for the formation of the insulating layer 4 can be shortened to improve the productivity.

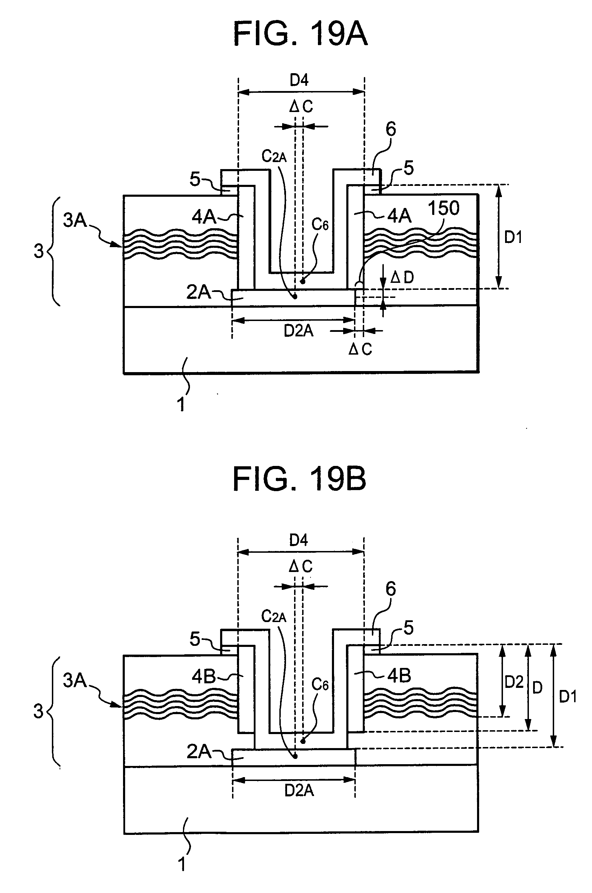

Further, the packaging density can be increased more in the printed wiring board 200 than in the printed wiring board 100. Referring to Fig. 19A, assuming that an outer diameter D4 of the tubular block layer 4A and a diameter D2A of the via land 2A are equal to each other in the printed wiring board 100, when a central point C_{2A} of the via land 2A is offset from a central point C₆ of the bottom of the via conductor 6 by ΔC, a region 150 where the via land 2A does not exist is generated by ΔC at the bottom of the via hole 20 in the process (Fig. 6) of forming the via hole 20 by the laser processing. In this region 150, the depth of the via hole 20 becomes D1+△D by the laser processing. This is because, since the via land 2A does not exist, the glass epoxy resin layer 3 is excessively dug away by the laser processing. After forming the via hole 20, the thermosetting resin is filled in to form the insulating layer 4 (Fig. 7). In this event, however, the resin does not enter the region 150 excessively dug up by the laser processing, so that a vacant space is formed. If moisture is contained in this vacant space, there arises possibility that when heat is applied in the later manufacturing process, the moisture expands to generate cracks or the like in a peripheral region. Therefore, in order to prevent generation of such a vacant space, the diameter D2A of the via land 2A should be set greater than the outer diameter D4 of the block layer 4A in the printed wiring board 100.

On the other hand, referring to Fig. 19B, the depth D of the via hole 40 for forming the block layer 4B is satisfactorily set as D2≤D<D1 in the printed wiring board 200. That is, it is not necessary that the lower end of the block layer 4B contacts with the via land 2A. Therefore, even if an outer diameter D4 of the block layer 4B and a diameter D2A of the via land 2A are equal to each other and a central point C_{2A} of the via land 2A is offset from a central point C₆ of the bottom of the via conductor 6 by ΔC, the disadvantage caused in the printed wiring board 100 does not occur in the printed wiring board 200.

In view of the foregoing, the diameter D2A of the via land 2A can be set smaller in the printed wiring board 200 than in the printed wiring board 100. Thus, the packaging density can be increased.

The foregoing preferred embodiments are examples wherein the present invention is applied to the via conductor 6 formed on the core layer 1. However, the present invention is also applicable to a via formed on a build-up layer. Further, the present invention is also applicable to a printed wiring board composed of only build-up layers, i.e. having no core layer. In these cases, the via land 2A and the glass epoxy resin layer 3 are formed on the build-up layer and not on the core layer 1.

Further, although the glass epoxy resin layer is used in the foregoing preferred embodiments, a layer obtained by impregnating the glass fibers with a resin other than the epoxy resin may be used instead of the glass epoxy resin layer.

Furthermore, the via conductor 6 is formed by the subtractive method in the foregoing preferred embodiments, but may be formed by another method such as the semi-additive method.

Hereinabove, the description has been given about the preferred embodiments of the present invention, which, however, are merely exemplification for carrying out the present invention. Accordingly, the present invention is not limited to the foregoing embodiments, but can be carried out by properly modifying the foregoing embodiments within a range not departing from the gist of the present invention.

As described above, the printed wiring board according to the present invention is useful as a module board such as a BGA (Ball Grid Array) board or a sub-board employed in a portable telephone or the like, particularly as a board requiring high-density packaging.

### 3. Brief Description of the Drawings:

Fig. 1 is a sectional view of a printed wiring board according to a first preferred embodiment of the present invention;
Fig. 2 is a sectional view showing a first process in a manufacturing method for the printed wiring board shown in Fig. 1;
Fig. 3 is a sectional view showing a process next to Fig. 2;
Fig. 4 is a sectional view showing a process next to Fig. 3;
Fig. 5 is a sectional view showing a process next to Fig. 4;
Fig. 6 is a sectional view showing a process next to Fig. 5;
Fig. 7 is a sectional view showing a process next to Fig. 6;
Fig. 8 is a sectional view showing a process next to Fig. 7;
Fig. 9 is a sectional view showing a process next to Fig. 8;
Fig. 10 is a sectional view showing a process next to Fig. 9;
Fig. 11 is a sectional view showing a process next to Fig. 10;
Fig. 12 is a sectional view of a printed wiring board according to a second preferred embodiment of the present invention;
Fig. 13 is a sectional view showing a process of forming a via hole in a manufacturing method for the printed wiring board shown in Fig. 12;
Fig. 14 is a sectional view showing a process next to Fig. 13;
Fig. 15 is a sectional view showing a process next to Fig. 14;
Fig. 16 is a sectional view showing a process next to Fig. 15;
Fig. 17 is a sectional view showing a process next to Fig. 16;
Fig. 18 is a sectional view showing a process next to Fig. 17;
Figs. 19A and 19B are sectional views each showing a printed wiring board wherein a position of a via relative to a via land is offset; and
Fig. 20 is a sectional view of a conventional printed wiring board.

## Claims

1. A printed wiring board comprising:
a base substrate;
a land conductor layer provided on said base substrate at least in part thereof;
an insulating layer provided on said base substrate and said land conductor layer, having a via hole reaching said land conductor layer, and containing glass fibers;
a via conductor layer covering a surface of said via hole and a surface of said insulating layer at least in the vicinity of an opening of said via hole and connected to said land conductor layer; and
a block layer provided between the surface of said via hole and said via conductor layer for preventing migration to said via conductor layer through the glass fibers inside said insulating layer.

2. The printed wiring board according to claim 1, wherein said block layer covers an inner wall of said insulating layer at least over a range from an uppermost end to a lowermost end where said glass fibers inside said insulating layer exist.

3. The printed wiring board according to claim 2, wherein a lower end of said block layer is located above a surface of said land conductor layer.

4. The printed wiring board according to claim 1, wherein said insulating layer is formed by a resin layer in which the glass fibers are buried.

5. The printed wiring board according to claim 1, wherein said block layer is formed by an insulating layer.

6. The printed wiring board according to claim 1, wherein said block layer is formed by a resin layer.

7. A method of manufacturing a printed wiring board, comprising the steps of:
(a) preparing a base substrate;
(b) providing a land conductor layer on said base substrate at least in part thereof;
(c) providing an insulating layer containing glass fibers so as to cover said base substrate and said land conductor layer;
(d) providing a via hole in said insulating layer, said via hole reaching said land conductor layer;
(e) providing a block layer on a surface of said via hole for preventing migration through the glass fibers inside said insulating layer; and
(f) providing a via conductor layer covering said block layer and a surface of said insulating layer at least in the vicinity of an opening of said via hole and connected to said land conductor layer.

8. A method of manufacturing a printed wiring board, comprising the steps of:
(a) preparing a base substrate;
(b) providing a land conductor layer on said base substrate at least in part thereof;
(c) providing an insulating layer containing glass fibers so as to cover said base substrate and said land conductor layer;
(d) providing a first via hole in said insulating layer over said land conductor layer;
(e) providing a block layer on a surface of said first via hole for preventing migration through the glass fibers inside said insulating layer;
(f) providing a second via hole in said first via hole where said block layer is provided, said second via hole reaching said land conductor layer; and
(g) providing a via conductor layer covering a surface of said second via hole, said block layer, and a surface of said insulating layer at least in the vicinity of an opening of said first via hole and connected to said land conductor layer.

9. A method of manufacturing a printed wiring board, comprising the steps of:
(a) preparing a base substrate;
(b) providing a land conductor layer on said base substrate at least in part thereof;
(c) providing an insulating layer containing glass fibers so as to cover said base substrate and said land conductor layer;
(d) providing a first via hole in said insulating layer over said land conductor layer;
(e) providing a second via hole in said first via hole, said second via hole reaching said land conductor layer, and providing a block layer on a surface of said first via hole for preventing migration through the glass fibers inside said insulating layer; and
(f) providing a via conductor layer covering a surface of said second via hole, said block layer, and a surface of said insulating layer at least in the vicinity of an opening of said first via hole and connected to said land conductor layer.

10. The method according to claim 9, wherein the step (e) of providing said second via hole and said block layer comprises the steps of:
filling said first via hole with an insulating material; and
removing a columnar portion, extending from a surface of said filled insulating material to reach a surface of said land conductor layer, of said filled insulating material and said insulating layer between a bottom of said first via hole and the surface of said land conductor layer so as to leave said filled insulating material of a predetermined thickness on the surface of said first via hole.

11. The method according to claim 8 or 9, wherein a lower end of said first via hole is located below a lowermost portion of said glass fibers inside said insulating layer and above a surface of said land conductor layer.
